# EUROPÄISCHE PATENTSCHRIFT

(11) **EP 3 788 389 B1**
(45) Veröffentlichungstag und Bekanntmachung des Hinweises auf die Patenterteilung: **27.12.2023**
(21) Anmeldenummer: 19724092.2
(22) Anmeldetag: 29.04.2019
(51) Int. Cl.: G01R 19/25, G01R 31/50, G01R 31/52, G01R 31/54, G01R 15/14, G01R 19/00, G01R 19/12, G01R 15/08, G01R 35/00

(54) **REDUNDANTE STROMMESSANORDNUNG MIT ERKENNUNG VON UNTERBRECHUNGEN EINES STROMKREISES**
REDUNDANT CURRENT-MEASURING ARRANGEMENT WITH DETECTION OF INTERRUPTIONS OF AN ELECTRIC CIRCUIT
DISPOSITIF DE MESURE DE COURANT REDONDANT COMPORTANT UNE DÉTECTION DE COUPURES DE CIRCUIT

(30) Priorität: 03.05.2018 DE 102018206804
(43) Veröffentlichungstag der Anmeldung: 10.03.2021
(73) Patentinhaber: Siemens Aktiengesellschaft, 80333 München (DE)
(72) Erfinder: SCHLARB, Eberhard, 79194 Gundelfingen (DE)
(74) Vertreter: Siemens Patent Attorneys
(86) Internationale Anmeldenummer: PCT/EP2019/060878
(87) Internationale Veröffentlichungsnummer: WO 2019/211221

(56) Entgegenhaltungen:
- EP-A1- 3 200 033
- WO-A1-2014/037465
- WO-A1-2017/167732
- DE-A1-102011 080 603
- DE-A1-102014 208 680

## Beschreibung

Die Erfindung betrifft eine Messanordnung zur redundanten Ermittlung eines Stromwerts nach Anspruch 1. Außerdem betrifft die Erfindung Verfahren zum Erkennen einer Unterbrechung eines Stromkreises in einer zur redundanten Ermittlung eines Stromwerts ausgebildeten Messanordnung nach Anspruch 4 und eine Kontrolleinheit für eine Messanordnung nach Anspruch 5.

Analoge Eingabemodule in Automatisierungssystemen erfassen Prozesswerte regelmäßig mittels Signalen, die einen Stromwert in einem Bereich von 0 bis 20mA oder von 4 bis 20mA aufweisen. Zur Erhöhung einer Verfügbarkeit wird ein entsprechender Messumformer der Eingabemodule beispielsweise parallel mit zwei korrespondierenden Eingangskanälen auf zwei redundant arbeitenden Eingangsmodulen verbunden. Daraus ergibt sich jedoch das Problem, dass der zu messende Strom sich auf die beiden Eingangskanäle verteilt, und seine Interpretation abhängig vom Zustand des anderen Eingangskanals erfolgen muss. Ein einseitiger Drahtbruch muss beispielsweise möglichst schnell erkannt und bei der Umrechnung des Messergebnisses berücksichtigt werden, um Fehlinterpretationen zu vermeiden.

Zur Erhöhung der Verfügbarkeit der Erfassung der Prozesswerte sind bisher folgende Möglichkeiten bekannt:
1) Die bereits erwähnte Parallelschaltung zweier aktiver Eingangskanäle: Ein Nachteil dieser Methode ist, dass sich der Stromwert an dem im Fall eines einseitigen Drahtbruchs verbleibenden Eingangskanal verdoppelt. Dieser Messfehler kann erst durch Erkennen des Drahtbruchs rechnerisch korrigiert werden und löst in dieser Zeit möglicherweise schon eine ungewollte Schalthandlung aus.
2) Reihenschaltung der Analogeingänge: Damit fließt der komplette Strom über beide Eingangskanäle. Nachteilig hierbei ist jedoch, dass diese Methode nur bei potentialgetrennten Eingangskanälen möglich ist und externe Beschaltungen erforderlich macht (beispielsweise eine Überbrückung jedes Eingangskanals mit Dioden um den Stromkreis im Fall eines Drahtbruchs nicht zu unterbrechen).
3) Parallelschaltung eines aktiven (niederohmigen) und eines passiven (hochohmigen) Eingangskanals: Ein Nachteil hierbei ist, dass nur der aktive Eingangskanal einen Drahtbruch erkennen kann. Ob der passive Eingangskanal verfügbar ist, zeigt sich erst, wenn aufgrund eines Fehlers am aktiven Eingangskanal auf den passiven Eingangskanal geschaltet wird.

Die Druckschrift DE 10 2012 205 401 A1 offenbart ein Sensorsystem zur redundanten Bestimmung eines über die Pole einer Batterie fließenden Batteriestroms.

In der Druckschrift EP 2 434 358 B1 ist ein System zur redundanten Versorgung einer Last mit einer Spannung offenbart.

In der WO 2017/167732 A1 ist eine Anordnung mit mindestens zwei redundanten, parallel geschalteten Analogeingabeeinheiten für einen Messstrom offenbart. Auf einer passiven Seite der Anordnung wird ein Strommesswiderstand (auch als Shunt bezeichnet) hochohmig geschaltet, sodass durch die Parallelkopplung der beiden Analogeingabeeinheiten die Spannung an einer Eingangsschaltung der aktiven Seite grob mitgemessen wird. Durch den Spannungsabfall in der Eingangsschaltung des aktiven Eingangs ist die gemessene Spannung auf der hochohmigen (passiven) Seite im Normalbetrieb immer um einen kleinen Faktor höher als auf der niederohmigen (aktiven) Seite der Anordnung. Eine Unterbrechung des Strommesskreises ("Drahtbruch") auf der passiven Seite kann durch die Verletzung dieses Kriteriums erkannt werden. Eine Erkennung einer Unterbrechung des Strommesskreises auf der aktiven Seite ist mit der in der WO 2017/167732 A1 offenbarten Anordnung bei 0 bis 20mA Messungen nicht, und bei 4mA bis 20mA Messungen nicht immer rechtzeitig möglich. Zudem kann die Unterbrechung auch auf der passiven Seite erst erkannt werden, nachdem ein oder mehrere fehlerhafte Strommesswerte erkannt wurden.

In der WO 2014/037465 A1 ist ein Verfahren zum Plausibilisieren eines Messergebnisses für einen elektrischen Strom durch einen in einer elektrischen Schaltung verschalteten Stromsensor offenbart.

Die DE 10 2011 080603 A1 offenbart ein Verfahren zur Messung elektrischen Stroms in einer elektrischen Schaltung mit einer Batterie.

In der DE 10 2014 208680 A1 ist ein Verfahren zur Überwachung von Stromsensoren bei der Ermittlung eines von einer Batterie abgegebenen elektrischen Gesamtstroms in einer elektrischen Schaltung beschrieben.

Der Erfindung liegt die Aufgabe zugrunde, ein effizientes Verfahren zur Detektion einer einseitigen Unterbrechung eines Strommesskreises in redundant ausgelegten Analogeingangskanälen eines Automatisierungssystems anzugeben, das insbesondere ein schnelleres Umschalten auf einen ungestörten Analogeingangskanal ermöglicht.

Diese Aufgabe wird gelöst durch eine Messanordnung zur redundanten Ermittlung eines Stromwerts mit wenigstens einem ersten Strommessmodul und wenigstens einem zweiten Strommessmodul nach Anspruch 1.

Zudem wird die Aufgabe gelöst durch Verfahren zum Erkennen einer Unterbrechung eines Stromkreises in einer zur redundanten Ermittlung eines Stromwerts ausgebildeten Messanordnung nach Anspruch 4.

Außerdem wird die Aufgabe gelöst durch eine Kontrolleinheit für eine Messanordnung nach Anspruch 5.

Vorteilhafte Weiterbildungen ergeben sich aus den abhängigen Ansprüchen.

Die erfindungsgemäße Messanordnung zur redundanten Ermittlung eines betragsmäßigen Wertes eines Stromflusses umfasst wenigstens ein erstes Strommessmodul und wenigstens ein zu dem ersten Strommessmodul parallel geschaltetes zweites Strommessmodul. Das erste Strommessmodul umfasst wenigstens einen ersten Analogeingang sowie wenigstens einen ersten Strommesswiderstand und eine dazugehörige Spannungsmesseinheit, um einen Stromwert eines in den Analogeingang und durch den ersten Strommesswiderstand fließenden Stroms zu ermitteln. Das zweite Strommessmodul umfasst wenigstens einen zweiten Analogeingang sowie wenigstens einen zweiten Strommesswiderstand und eine dazugehörige Spannungsmesseinheit, um einen Stromwert eines in den zweiten Analogeingang und durch den zweiten Strommesswiderstand fließenden Stroms zu ermitteln.

Die Messanordnung ist dadurch gekennzeichnet, dass sie eine Kontrolleinheit umfasst, das dazu ausgebildet und vorgesehen ist, einen graduellen Verlauf der von den Spannungsmesseinheiten ermittelten Spannungen zu erfassen, und bei Vorliegen einer Gegenläufigkeit der graduellen Verläufe der Spannungen ein Strommessmodul von einer Ermittlung des betragsmäßigen Wertes des Stromflusses auszunehmen. Der Stromfluss kann dabei einer strommessmodulinternen Geberversorgung oder einer beliebigen externen Stromquelle entstammen. Insbesondere entstammt der Stromfluss einem Messumformer, der beispielsweise einen Ausgangsstrom in einem Bereich von 0 bis 20 Milliampere bereitstellt.

Die Strommessmodule sind dazu ausgebildet, in an sich bekannter Weise mittels eines Referenzwiderstands (Shunt-Widerstand) und einer Spannungsmesseinheit einen betragsmäßigen Wert eines Stromflusses zu ermitteln, der aus einem Messumformer gesteuert wird und durch den Referenzwiderstand bzw. durch das jeweilige Strommessmodul fließt. Der Messumformer kann dabei durch eine, oder zur Erhöhung der Verfügbarkeit durch mehrere parallelgeschaltete Geberversorgungen, oder durch eine externe Quelle gespeist werden. Die Strommessmodule sind dabei parallel geschaltet, um im Falle des Ausfalls eines der beiden Module eine Fortsetzung der Strommessung zu ermöglichen.

Die Kontrolleinheit kann jede beliebige Einheit sein, die dazu ausgebildet ist, Signale von den Spannungsmesseinheiten zu empfangen und zu bewerten. Insbesondere kann die Kontrolleinheit für diese Mittel einen Mikroprozessor umfassen.

Tritt beispielsweise in dem ersten Strommessmodul eine Unterbrechung eines Stromkreislaufs auf, so sinkt die von dem ersten Strommessmodul ermittelte Spannung, da kein Strom mehr durch den ersten Strommesswiderstand fließen kann. Auf der anderen Seite steigt die von dem zweiten Strommessmodul ermittelte Spannung, da der komplette Strom nun über das zweite Strommessmodul fließt. Dadurch, dass das Kontrolleinheit erfindungsgemäß dazu ausgebildet ist, diese Gegenläufigkeit der graduellen Verläufe der ermittelten Spannungen zu erkennen, ist die Messanordnung dazu in der Lage, schnell und zuverlässig auf die Unterbrechung zu reagieren, indem das von der Unterbrechung des Stromkreislaufes betroffene Strommessmodul von der Ermittlung des Wertes für den Stromfluss ausgenommen wird.

Bei einer vorteilhaften Weiterbildung der Erfindung ist die Kontrolleinheit dazu ausgebildet und vorgesehen, einen Widerstandswert des Strommesswiderstands des wenigstens einen Strommessmoduls zu ändern, welches Strommessmodul zuvor nicht von der Ermittlung des betragsmäßigen Wertes des (beispielsweise aus einer Geberversorgung fließenden) Stromflusses ausgenommen wurde. War der Strommesswiderstand des nicht von der Stromkreisunterbrechung betroffenen Strommessmoduls vor der Erkennung der gegenläufigen Spannungsgradienten beispielsweise in einem hochohmigen Zustand, so veranlasst die Kontrolleinheit bzw. damit verbundene Elemente, dass der Strommesswiderstand des nicht betroffenen Strommessmoduls in einen niederohmigen Zustand wechselt, um aktiv den Betrag des Stromflusses zu ermitteln.

Die Kontrolleinheit kann dabei räumlich und funktional unabhängig von den Spannungsmesseinheiten angeordnet sein, wobei die Kontrolleinheit hierbei über entsprechende Verbindungen verfügen muss, um signaltechnisch auf die Spannungsmesseinheiten zuzugreifen.

Besonders bevorzugt ist die Kontrolleinheit räumlich und/oder funktional einer der Spannungsmesseinheiten zugeordnet. Dies bedeutet, dass die Kontrolleinheit unmittelbar Zugriff auf die von der Spannungsmesseinheit ermittelten Werte hat und insbesondere keine oder nur vernachlässigbare Verzögerungen zwischen dem Ermitteln der fehlerhaften Spannungsmesswerte und dem Ergreifen entsprechender Maßnahmen auftreten. Das in einer der beiden Spannungsmesseinheiten angeordnete Kontrolleinheit ist dabei mit der anderen Spannungsmesseinheit des anderen Strommessmoduls verbunden, um einen Vergleich des graduellen Verlaufs der ermittelten Spannungswerte zu ermöglichen.

Es ist alternativ auch möglich, zwei oder mehr Kontrolleinheiten vorzusehen, die jeweils räumlich und/oder funktional einer der Spannungsmesseinheiten zugeordnet sind, und die mittels eines wechselseitigen Datenaustauschs die zuvor beschriebene Funktionalität bereitstellen.

Bei einer vorteilhaften Weiterbildung der Erfindung sind wenigstens zwei der Spannungsmesseinheiten dazu ausgebildet, Spannungen mittels eines integrierenden Messverfahrens zu ermitteln. Bei einem solchen integrierenden Messverfahren wird ein Spannungsmesswert aus vielen Teilmessungen in einem Messintervall ermittelt. Aus diesen Teilmessungen wird sehr schnell (beispielsweise innerhalb von zehn Prozent einer Dauer eines Messintervalls, d.h. deutlich früher als der endgültige Spannungsmesswert selbst ermittelt wird) erkennbar, dass sich die ermittelten Spannungswerte in beiden Strommessmodulen im Fall einer Unterbrechung eines Stromkreises in entgegengesetzte Richtungen bewegen.

Mit anderen Worten kann schnell erkannt werden, dass sich die graduellen Verläufe der ermittelten Spannungswerte gegenläufig bewegen, bevor ein fehlerhafter Messwert überhaupt von den Spannungsmesseinheiten ausgegeben wird. Ein Widerstandswert wenigstens eines der Strommesswiderstände kann dadurch schneller geändert werden als dies bei bislang bekannten Messanordnungen der Fall war.

Die Aufgabe wird weiterhin durch ein Verfahren zum Erkennen einer Unterbrechung eines Stromkreises in einer zur redundanten Ermittlung eines betragsmäßigen Wertes eines (beispielsweise aus einer Geberversorgung fließenden) Stromflusses ausgebildeten Messanordnung gelöst, wobei die Messanordnung wenigstens ein erstes Strommessmodul und wenigstens ein zu dem ersten Strommessmodul parallel geschaltetes zweites Strommessmodul umfasst.

Das erste Strommessmodul umfasst wenigstens einen ersten Analogeingang sowie wenigstens einen ersten Strommesswiderstand und eine dazugehörige Spannungsmesseinheit, um einen Stromwert eines in den Analogeingang und durch den ersten Strommesswiderstand fließenden Stroms zu ermitteln.

Das zweite Strommessmodul umfasst wenigstens einen zweiten Analogeingang sowie wenigstens einen zweiten Strommesswiderstand und eine dazugehörige Spannungsmesseinheit, um einen Stromwert eines in den zweiten Analogeingang und durch den zweiten Strommesswiderstand fließenden Stroms zu ermitteln.

Das Verfahren ist dadurch gekennzeichnet, dass ein gradueller Verlauf der von den Spannungsmesseinheiten ermittelten Spannungen mittels einer Kontrolleinheit erfasst wird, und bei Vorliegen einer Gegenläufigkeit der graduellen Verläufe der Spannungen ein Strommessmodul von einer Ermittlung des betragsmäßigen Wertes des Stromflusses ausgenommen wird.

Vorzugsweise ist die Kontrolleinheit räumlich und/oder funktional einer der Spannungsmesseinheiten zugeordnet, worauf zuvor bereits hingewiesen wurde.

Die Aufgabe wird ebenso durch eine Kontrolleinheit für eine erfindungsgemäße Messanordnung zur Implementierung eines Verfahrens wie zuvor erläutert gelöst.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung des Ausführungsbeispiels, das im Zusammenhang mit den Zeichnungen näher erläutert wird.

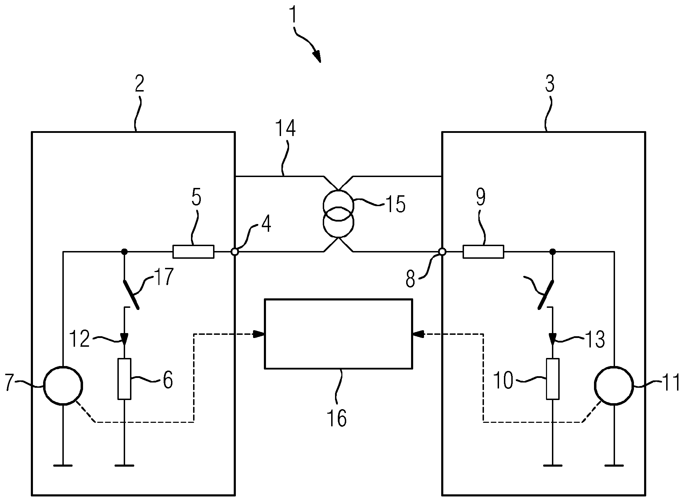

Die Figur zeigt ein Schaltbild einer erfindungsgemäßen Messanordnung 1. Die Messanordnung 1 umfasst ein erstes Strommessmodul 2 und ein zweites Strommessmodul 3. Das erste Strommessmodul 2 umfasst einen ersten Analogeingang 4 mit einem Eingangswiderstand 5, einen ersten Strommesswiderstand 6 und eine Spannungsmesseinheit 7 (in der Figur auch mit U1 bezeichnet). Das zweite Strommessmodul 3 umfasst einen zweiten Analogeingang 8 mit einem Eingangswiderstand 9, einen zweiten Strommesswiderstand 10 und eine Spannungsmesseinheit 11 (in der Figur auch mit U2 bezeichnet).

Jedes der beiden Strommessmodule 2, 3 ist dazu ausgebildet, mittels des Strommesswiderstands 6, 10 und der dazugehörigen Spannungsmesseinheit 7, 11 einen Stromwert 12, 13 durch die jeweiligen Strommesswiderstände 6, 10 zu ermitteln. Die Messanordnung 1 dient zur redundanten Ermittlung eines betragsmäßigen Wertes eines aus einer Geberversorgung 14 fließenden Stromflusses 15.

Das erste Strommessmodul 2 ist in seinem Grundzustand hochohmig bzw. passiv ausgelegt. Dies bedeutet, dass der erste Strommesswiderstand 6 im Vergleich zu dem zweiten Strommesswiderstand einen verhältnismäßig hohen Widerstandswert aufweist. Beispielweise kann der hochohmige erste Strommesswiderstand 6 einen um einen Faktor 1000 höheren Widerstandswert als der niederohmige zweite Strommesswiderstand 10 aufweisen. Aufgrund des hohen ersten Strommesswiderstands 6 ist der Stromwert 12, der durch den ersten Strommesswiderstand 6 bzw. durch das erste Strommessmodul 2 fließt, um Größenordnungen geringer als der Stromwert 13, der durch den zweiten Strommesswiderstand 10 bzw. durch das zweite Strommessmodul 3 fließt.

Beide Strommessmodule 2, 3 sind parallel geschaltet. Der Eingangswiderstand 5 des ersten Strommessmoduls 2 weist einen geringen Widerstandswert auf, wodurch in Kombination mit dem geringen Stromwert 12, der durch das erste Strommodul 2 fließt, nur eine zu vernachlässigende Spannung über dem Eingangswiderstand 5 abfällt. Im Gegensatz hierzu ist die Spannung über dem Eingangswiderstand 9 des zweiten Strommessmoduls 3 aufgrund des deutlich höheren Stromwerts 13, der durch das zweite Strommessmodul 3 fließt, nicht vernachlässigbar. Die Spannung, die die Spannungsmesseinheit 11 über dem zweiten Strommesswiderstand 10 des zweiten Strommessmoduls 3 misst, ist daher immer um einen berechenbaren Betrag größer als die Spannung, die die Spannungsmesseinheit 7 über dem ersten Strommesswiderstand 6 des ersten Strommessmoduls 2 misst.

Die Messanordnung 1 weist zudem eine Kontrolleinheit 16 auf, die jeweils eine Verbindung zu der Spannungsmesseinheit 7 des ersten Strommessmoduls 2 und zu der Spannungsmesseinheit 11 des zweiten Strommessmoduls 3 aufweist. Ein Drahtbruch 17, d.h. eine Unterbrechung des Stromkreises auf der passiven Seite (erstes Strommessmodul 2) kann durch die Verletzung dieses Kriteriums mittels der erfindungsgemäßen Messanordnung 1 einfach und schnell erkannt werden. Die Kontrolleinheit 16 nimmt das erste Strommessmodul 2 entsprechend von einer Ermittlung des betragsmäßigen Wertes des aus der Geberversorgung 14 fließenden Stromflusses 15 aus.

Tritt auf der aktiven Seite (zweites Strommessmodul 3) ein einseitiger Drahtbruch auf, so fällt die über dem zweiten Strommesswiderstand 10 ermittelte Spannung schnell ab. Gleichzeitig steigt auf der passiven Seite (erstes Strommessmodul 2) aufgrund des hochohmigen Strommesswiderstands 6 die die über dem ersten Strommesswiderstand 6 ermittelte Spannung schnell an. Das gleichzeitige Auftreten dieser gegenläufigen Gradienten wird von dem Kontrolleinheit 16 erkannt. Hierzu wertet die Kontrolleinheit direkt einzelne Integrationsstufen (Teilmesswerte) der auf Basis eines integrierenden Messverfahrens verfahrenden Spannungsmesseinheiten 7, 11 aus.

Das Erkennen der gegenläufigen Gradienten der ermittelten Spannungswerte führt unmittelbar zum Abbruch eines laufenden Messintervalls. Gleichzeitig wird der Widerstandswert des hochohmigen ersten Strommesswiderstands 6 deutlich verringert, so dass das erste Strommessmodul 2 als aktive Seite fungiert. Die Kontrolleinheit 16 nimmt das zweite Strommessmodul 3 zudem entsprechend von einer Ermittlung des betragsmäßigen Wertes des aus der Geberversorgung 14 fließenden Stromflusses 15 aus.

Während dieses Vorgangs wird der aktuelle Messwert eingefroren bis auf Basis der neuen Strommesswiderstände 6, 10 ein neues Messintervall beendet ist. Damit lässt sich die Weitergabe eines verfälschten Messwertes beispielsweise an eine übergeordnete Automatisierung vermeiden.

Durch die erfindungsgemäße Messanordnung 1 wird eine maximale temporäre Verfälschung des Messwertes bis zur Erkennung des Drahtbruchs bzw. der Unterbrechung eines Strommesskreises eines Strommessmoduls zeitlich und inhaltlich deutlich verringert.

## Patentansprüche

1. Messanordnung (1) zur redundanten Ermittlung eines betragsmäßigen Wertes eines Stromflusses (15), wobei die Messanordnung (1) wenigstens ein erstes Strommessmodul (2) und wenigstens ein zu dem ersten Strommessmodul (2) parallel geschaltetes zweites Strommessmodul (3) aufweist,
das erste Strommessmodul (2) umfassend wenigstens einen ersten Analogeingang (4) sowie wenigstens einen ersten Strommesswiderstand (6) und eine dazugehörige Spannungsmesseinheit (7), um einen Stromwert (12) eines in den Analogeingang (4) und durch den ersten Strommesswiderstand (6) fließenden Stroms zu ermitteln,
das zweite Strommessmodul (3) umfassend wenigstens einen zweiten Analogeingang (8) sowie wenigstens einen zweiten Strommesswiderstand (10) und eine dazugehörige Spannungsmesseinheit (11), um einen Stromwert (13) eines in den zweiten Analogeingang (8) und durch den zweiten Strommesswiderstand (10) fließenden Stroms zu ermitteln, wobei die Messanordnung (1) eine Kontrolleinheit (16) umfasst,
**dadurch gekennzeichnet, dass**
die wenigstens zwei Spannungsmesseinheiten (7, 11) dazu ausgebildet sind, Spannungen mittels eines integrierenden Messverfahrens zu ermitteln,
und dass die Kontrolleinheit (16) dazu ausgebildet und vorgesehen ist, einen graduellen Verlauf der von den Spannungsmesseinheiten (7, 11) ermittelten Spannungen zu erfassen, und bei Vorliegen einer Gegenläufigkeit der graduellen Verläufe der Spannungen dasjenige Strommessmodul (2, 3) von einer Ermittlung des betragsmäßigen Wertes des Stromflusses (15) auszunehmen, das von einer Unterbrechung eines Stromkreislaufes betroffen ist, wobei eine Feststellung, welches Strommessmodul (2, 3) betroffen ist, durch eine jeweilige hochohmige-/und niederohmige Beschaltung erreicht wird,
und wobei die Kontrolleinheit (16) dazu ausgebildet ist, zur Erfassung der Gegenläufigkeit der graduellen Verläufe der Spannungen direkt einzelne Integrationsstufen der auf Basis eines integrierenden Messverfahrens verfahrenden Spannungsmesseinheiten (7, 11) auszuwerten.

2. Messanordnung (1) nach Anspruch 1, bei der die Kontrolleinheit (16) dazu ausgebildet und vorgesehen ist einen Widerstandswert des Strommesswiderstands (6, 10) des wenigstens einen Strommessmoduls (2, 3) zu ändern, welches Strommessmodul (2, 3) zuvor nicht von der Ermittlung des betragsmäßigen Wertes des Stromflusses (15) ausgenommen wurde.

3. Messanordnung (1) nach Anspruch 1 oder 2, bei der die Kontrolleinheit (16) räumlich und/oder funktional einer der Spannungsmesseinheiten (7, 11) zugeordnet ist.

4. Verfahren zum Erkennen einer Unterbrechung eines Stromkreises in einer zur redundanten Ermittlung eines betragsmäßigen Wertes eines Stromflusses (15) ausgebildeten Messanordnung (1), wobei die Messanordnung (1) wenigstens ein erstes Strommessmodul (2) und wenigstens ein zu dem ersten Strommessmodul (2) parallel geschaltetes zweites Strommessmodul (3) umfasst,
das erste Strommessmodul (2) umfassend wenigstens einen ersten Analogeingang (4) sowie wenigstens einen ersten Strommesswiderstand (6) und eine dazugehörige Spannungsmesseinheit (7), um einen Stromwert (12) eines in den Analogeingang (4) und durch den ersten Strommesswiderstand (6) fließenden Stroms zu ermitteln,
das zweite Strommessmodul (3) umfassend wenigstens einen zweiten Analogeingang (8) sowie wenigstens einen zweiten Strommesswiderstand (10) und eine dazugehörige Spannungsmesseinheit (11), um einen Stromwert (13) eines in den zweiten Analogeingang (8) und durch den zweiten Strommesswiderstand (10) fließenden Stroms zu ermitteln,
**dadurch gekennzeichnet, dass**
die wenigstens zwei Spannungsmesseinheiten (7, 11) Spannungen mittels eines integrierenden Messverfahrens ermitteln,
und dass ein gradueller Verlauf der von den Spannungsmesseinheiten (7, 11) ermittelten Spannungen mittels einer Kontrolleinheit (16) erfasst wird, und bei Vorliegen einer Gegenläufigkeit der graduellen Verläufe der Spannungen dasjenige Strommessmodul (2, 3) von einer Ermittlung des betragsmäßigen Wertes des Stromflusses (15) ausgenommen wird, das von einer Unterbrechung eines Stromkreislaufes betroffen ist, wobei eine Feststellung, welches Strommessmodul (2, 3) betroffen ist, durch eine jeweilige hochohmige-/und niederohmige Beschaltung erreicht wird,
und wobei die Kontrolleinheit (16) zur Erfassung der Gegenläufigkeit der graduellen Verläufe der Spannungen direkt einzelne Integrationsstufen der auf Basis eines integrierenden Messverfahrens verfahrenden Spannungsmesseinheiten (7, 11) auswertet.

5. Kontrolleinheit (16) für eine Messanordnung (1) gemäß einem der Ansprüche 1 bis 3 ausgebildet zur Implementierung des Verfahrens gemäß Anspruch 4.

## Claims

1. Measuring arrangement (1) for the redundant
determination of a quantitative value of a current flow (15), wherein the measuring arrangement (1) has at least one first current-measuring module (2) and at least one second current-measuring module (3) connected in parallel with the first current-measuring module (2),
the first current-measuring module (2) comprising at least one first analogue input (4) and at least one first current-measuring resistor (6) and an associated voltage-measuring unit (7) in order to determine a current value (12) of a current flowing into the analogue input (4) and through the first current-measuring resistor (6),
the second current-measuring module (3) comprising at least one second analogue input (8) and at least one second current-measuring resistor (10) and an associated voltage-measuring unit (11) in order to determine a current value (13) of a current flowing into the second analogue input (8) and through the second current-measuring resistor (10),
wherein
the measuring arrangement (1) comprises a control unit (16), **characterised in that**
the at least two voltage-measuring units (7, 11) are embodied to determine voltages by means of an integrating measuring method,
and that the control unit (16) is embodied and provided to detect a gradual course of the voltages determined by the voltage-measuring units (7, 11) and in the presence of a reverse flow of the gradual courses of the voltages, to exclude that current-measuring module (2, 3) from a determination of the quantitative value of the current flow (15), which is affected by an interruption in an electric circuit, wherein a conclusion as to which current-measuring module (2, 3) is affected is drawn by a respective high-resistance and/or low-resistance circuitry,
and wherein the control unit (16) is embodied to directly evaluate individual integration levels of the voltage-measuring units (7, 11) moving on the basis of an integrating measuring method in order to detect the reverse flow of the gradual courses of the voltages.

2. Measuring arrangement (1) according to claim 1, in which the control unit (16) is embodied and provided to change a resistance value of the current-measuring resistor (6, 10) of the at least one current-measuring module (2, 3), which current-measuring module (2, 3) was previously not excluded from the determination of the quantitative value of the current flow (15).

3. Measuring arrangement (1) according to claim 1 or 2, in which the control unit (16) is assigned spatially and/or functionally to one of the voltage-measuring units (7, 11).

4. Method for detecting an interruption in an electric circuit in a measuring arrangement (1) embodied for the redundant determination of a quantitative value of a current flow (15), wherein the measuring arrangement (1) has at least one first current-measuring module (2) and at least one second current-measuring module (3) connected in parallel with the first current-measuring module (2),
the first current-measuring module (2) comprising at least one first analogue input (4) and at least one first current-measuring resistor (6) and an associated voltage-measuring unit (7) in order to determine a current value (12) of a current flowing into the analogue input (4) and through the first current-measuring resistor (6),
the second current-measuring module (3) comprising at least one second analogue input (8) and at least one second current-measuring resistor (10) and an associated voltage-measuring unit (11) in order to determine a current value (13) of a current flowing into the second analogue input (8) and through the second current-measuring resistor (10),
**characterised in that**
the at least two voltage measuring units (7, 11) determine voltages by means of an integrating measuring method,
and that a gradual course of the voltages determined by the voltage-measuring units (7, 11) is detected by means of a control unit (16), and in the presence of a reverse flow of the gradual courses of the voltages, that current-measuring module (2, 3) is excluded from a determination of the quantitative value of the current flow (15) that is affected by an interruption in an electric circuit, wherein a conclusion as to which current-measuring module (2, 3) is affected is drawn by a respective high-resistance and/or low-resistance circuitry,
and wherein the control unit (16) directly evaluates individual integration levels of the voltage-measuring units (7, 11) moving on the basis of an integrating measuring method in order to detect the reverse flow of the gradual courses of the voltages.

5. Control unit (16) for a measuring arrangement (1) according to one of claims 1 to 3, embodied for the implementation of the method according to claim 4.

## Revendications

1. Dispositif (1) de mesure de détermination redondante d'une valeur absolue d'un flux (15) de courant, dans lequel le dispositif (1) de mesure a au moins un premier module (2) de mesure du courant et au moins un deuxième module (3) de mesure du courant monté en parallèle avec le premier module (2) de mesure du courant,
le premier module (2) de mesure du courant comprenant au moins une première entrée (4) analogique, ainsi qu'au moins une première résistance (6) de mesure du courant et une unité (7) de mesure de tension lui appartenant, pour déterminer une valeur (12) d'un courant passant dans l'entrée (4) analogique et dans la première résistance (6) de mesure du courant,
le deuxième module (3) de mesure du courant comprenant au moins une deuxième entrée (8) analogique, ainsi qu'au moins une deuxième résistance (10) de mesure du courant et une unité (11) de mesure de tension, qui lui appartient, afin de déterminer une valeur (13) d'un courant passant dans la deuxième entrée (8) analogique et dans la deuxième résistance (10) de mesure du courant,
dans lequel le dispositif (1) de mesure comprend une unité (16) de contrôle,
**caractérisé en ce que**
les au moins deux unités (7, 11) de mesure de tension sont constituées pour déterminer des tensions au moyen d'un procédé de mesure d'intégration,
et **en ce que** l'unité (16) de contrôle est constituée et prévue pour détecter une courbe graduelle des tensions déterminées par les unités (7, 11) de mesure de tension et, en présence d'une contrariété des courbes graduelles des tensions, exclure le module (2, 3) de mesure de courant d'une détermination de la valeur absolue du flux (15) de courant, qui est concerné par une interruption d'un circuit de courant, dans lequel on obtient une constatation du point de savoir celui des modules (2, 3) de mesure de courant, qui est concerné, par une connexion respective à grande valeur ohmique / et à petite valeur ohmique,
et dans lequel l'unité (16) de contrôle est constituée, pour la détection de la contrariété des courbes graduelles de tension, pour analyser directement divers étages d'intégration des unités (7, 11) de mesure de tension procédant sur la base d'un procédé de mesure intégré.

2. Dispositif (1) de mesure suivant la revendication 1, dans lequel l'unité (16) de contrôle est constituée et prévue pour modifier une valeur de la résistance (6, 10) de mesure de courant du au moins un module (2, 3) de mesure du courant, lequel module (2, 3) de mesure du courant n'a pas été exclu auparavant de la détermination de la valeur absolue du flux (15) de courant.

3. Dispositif (1) de mesure suivant la revendication 1 ou 2, dans lequel l'unité (16) de contrôle est associée dans l'espace et/ou fonctionnellement à l'une des unités (7, 11) de mesure de tension.

4. Procédé de détection d'une interruption d'un circuit dans un dispositif (1) de mesure constitué pour la détermination redondante d'une valeur absolue d'un flux (15) de courant, dans lequel le dispositif (1) de mesure comprend au moins un premier module (2) de mesure du courant et au moins un deuxième module (3) de mesure du courant monté en parallèle avec le premier module (2) de mesure du courant,
le premier module (2) de mesure du courant comprenant au moins une première entrée (4) analogique ainsi qu'au moins une première résistance (6) de mesure du courant et une unité (7) de mesure de tension lui appartenant, pour déterminer une valeur (12) d'un courant passant dans l'entrée (4) analogique et dans la première résistance (6) de mesure du courant,
le deuxième module (3) de mesure du courant comprenant au moins une deuxième entrée (8) analogique ainsi qu'au moins une deuxième résistance (10) de mesure du courant et une unité (11) de mesure de tension, qui lui appartient, afin de déterminer une valeur (13) d'un courant passant dans la deuxième entrée (8) analogique et dans la deuxième résistance (10) de mesure du courant, **caractérisé en ce que**
les au moins deux unités (7, 11) de mesure de tension déterminent des tensions au moyen d'un procédé de mesure intégré,
et **en ce que** l'on détecte, au moyen d'une unité (16) de contrôle, une courbe graduelle des tensions déterminées par les unités (7, 11) de mesure de tension et, en présence d'une contrariété des courbes graduelles des tensions, on exclut le module (2, 3) de mesure de courant d'une détermination de la valeur absolue du flux (15) de courant, qui est concerné par une interruption d'un circuit, dans lequel on obtient une constatation du point de savoir celui des modules (2, 3) de mesure du courant qui est concerné, par une connexion respective à grande valeur ohmique / et à petite valeur ohmique,
et dans lequel l'unité (16) de contrôle analyse, pour la détection de la contrariété des courbes graduelles des tensions, directement divers étages d'intégration des unités (7, 11) de mesure de tension procédant sur la base d'un procédé de mesure d'intégration.

5. Unité (16) de contrôle pour un dispositif (1) de mesure suivant l'une des revendications 1 à 3, constituée pour la mise en œuvre du procédé suivant la revendication 4.
